Europäisches Patentamt

(19) European Patent Office

Office européen des brevets

(11) Veröffentlichungsnummer: **0 012 961 B1**

(12) EUROPÄISCHE PATENTSCHRIFT

(45) Veröffentlichungstag der Patentschrift:
17.11.82

(21) Anmeldenummer: 79105196.4

(22) Anmeldetag: 14.12.79

(51) Int. Cl.³: **G 01 R 23/15,** H 02 J 3/46,
H 02 P 9/04, H 02 H 3/48

(54) **Einrichtung zur Bestimmung von die Netzfrequenz beeinflussenden Störungen in elektrischen Energieversorgungsnetzen und Verwendung einer derartigen Einrichtung in einer adaptiven Frequenzregelung für elektrische Energieversorgungsnetze.**

(30) Priorität: 15.12.78 DE 2854315

(43) Veröffentlichungstag der Anmeldung:
09.07.80 Patentblatt 80/14

(45) Bekanntmachung des Hinweises auf die Patenterteilung:
17.11.82 Patentblatt 82/46

(84) Benannte Vertragsstaaten:
CH FR IT NL SE

(56) Entgegenhaltungen:
DE-A-2 318 875      US-A-4 074 191
FR-A-2 137 107      US-A-4 137 496
US-A-3 717 818      US-A-4 137 497
US-A-3 932 737      US-A-4 144 491
US-A-3 993 984      US-A-4 157 457
US-A-4 037 151      US-A-4 236 112
US-A-4 073 009

IEEE TRANSACTIONS ON POWER APPARATUS AND SYSTEMS, vol. PAS-88, Nr. 6, Juli 1969, Seiten 812—817, New York, US, CH. J. DURKIN et al., »An underfrequency relay with frequency decayrate compensation«.

(73) Patentinhaber: Grimm, German, Dipl.-Ing., Am Feldrain 8, D-8061 Hebertshausen (DE)

(72) Erfinder: Grimm, German, Dipl.-Ing., Am Feldrain 8, D-8061 Hebertshausen (DE)

(74) Vertreter: Dorner, Jörg, Dr.-Ing. et al, Landwehrstrasse 37, D-8000 München 2 (DE)

## Einrichtung zur Bestimmung von die Netzfrequenz beeinflussenden Störungen in elektrischen Energieversorgungsnetzen und Verwendung einer derartigen Einrichtung in einer adaptiven Frequenzregelung für elektrische Energieversorgungsnetze

Die Erfindung bezieht sich auf eine Einrichtung zur Bestimmung von die Netzfrequenz beeinflussenden Störungen in elektrischen Energieversorgungsnetzen mit einer Meßschaltung zur Ermittlung der Abweichung der Netzfrequenz von einer Sollwertfrequenz und einer weiteren Meßschaltung zur Ermittlung der Frequenzänderungsgeschwindigkeit. Auch bezieht sich die Erfindung auf die Verwendung einer derartigen Einrichtung in einer adaptiven Frequenzregeleinrichtung für elektrische Energieversorgungsnetze.

Entsprechende Einrichtungen und ihre Verwendung sind aus »VDE-Fachberichte« Nr. 30, VDE-Verlag GmbH, Berlin, Seiten 303 bis 312 aufgrund einer Abhandlung mit dem Titel »Einsatz eines Mikrorechners zur nichtlinearen Filterung des Netzfrequenzrauschens bei der Primärregelung« bekannt.

Bei der bekannten Einrichtung besteht eine Anpassung des Regelverhaltens an die jeweils aufgetretene Netzstörung in einer Verschiebung des Regelnullpunktes abhängig von der aufgetretenen Regelabweichung der Netzfrequenz oder in der Bemessung eines toten Bandes der Regelung oder einer Unempfindlichkeitszone abhängig von der Frequenzänderungsgeschwindigkeit bei Auftreten eines Störungsereignisses. Die bekannten Einrichtungen besitzen somit die erwähnten Meßschaltungen zur Ermittlung der Abweichung der Netzfrequenz bzw. zur Ermittlung der Frequenzänderungsgeschwindigkeit, wobei die Meßschaltungs-Ausgangssignale weiterverwertet werden.

Aufgabe der vorliegenden Erfindung ist es, eine Einrichtung der eingangs beschriebenen Art so auszugestalten, daß sie vergleichsweise genaue Informationen über das Störungsereignis liefert. Sollen diese Informationen zur adaptiven Frequenzregelung verwendet werden, so soll erfindungsgemäß einerseits zwar eine gegenüber regulären Frequenzschwankungen verhältnismäßig unempfindliche Regelung ermöglicht werden, die jedoch beim Auftreten von starken Störungen sehr rasch und wirkungsvoll reagiert.

Die soeben angegebene Aufgabe wird erfindungsgemäß dadurch gelöst, daß die erstgenannte Meßschaltung eine Verzögerungs- und Tastschaltung mit mehreren Ausgängen enthält, von deren einem ein Signal entsprechend der Frequenz vor Auftritt der Störung und von deren anderem ein derartiges Signal entsprechend der Frequenz eine kurze Zeit, insbesondere etwa 10 Sekunden, nach Störungsauftritt abnehmbar ist, daß ferner eine an die weitere Meßschaltung angeschlossene Zeitsteuereinrichtung mit mehreren Taktsignalausgängen zur Steuerung der Verzögerungs- und Tastschaltung vorgesehen ist und daß die Ausgangssignale der Verzögerungs- und Tastschaltung in einem Vergleicher einspeisbar sind, dessen Ausgang mit einem Anzeigegerät gekoppelt ist, von welchem eine Anzeige entsprechend der am Störungsort zufließenden oder abfließenden Leistung ablesbar ist.

Vorzugsweise ist die Kopplung des Vergleicherausgangs mit dem Anzeigegerät über eine Multiplikationsschaltung vorgenommen, in welcher das Vergleicherausgangssignal mit einem wählbaren Faktor multipliziert werden kann.

Gemäß einer vorteilhaften Weiterbildung können die Multiplikationsschaltung und ein der zweitgenannten Meßschaltung nachgeschalteter Maximalwerthaltekreis, der ein Signal entsprechend der maximal auftretenden Frequenzänderungsgeschwindigkeit abgibt, eine Rechenschaltung beaufschlagen, welche ein Ausgangssignal Z nach folgender Rechenoperation erzeugt:

$$Z = Z_0 \, e^{\alpha \frac{PA}{f_{max}}}$$

worin $Z_0$ und $\alpha$ in die Rechenschaltung eingegebene, wählbare Konstanten sind, PA das Ausgangssignal der Multplikationsschaltung bedeutet und $f_{max}$ das Ausgangssignal des Maximalwerthaltekreises bedeutet und wobei die Rechenschaltung an ein zweites Anzeigegerät angeschlossen ist, von welchem eine Anzeige entsprechend einer Entfernung zwischen Meßort und Störungsort oder vorzugsweise eine Anzeige entsprechend der Ersatzimpedanz des betreffenden Energieversorgungsnetzes zwischen Beobachtungs- und Störungsort ablesbar ist.

Die Anordnung kann so getroffen sein, daß die Verzögerungs- und Tastschaltung zwei hintereinandergeschaltete, wechselweise betätigte und eingangsseitig von einem Frequenz-Istwertsignal beaufschlagte Tast- und Haltekreise sowie diesen jeweils nachgeschaltete weitere Tast- und Haltekreise als Speicherstufen enthält, von welch letzteren einer durch die Zeitsteuereinrichtung derart gesteuert ist, daß er vom Ausgang des zuerst genannten Tast- und Haltekreispaares ein Signal entsprechend der Frequenz vor Auftreten der Störung zur Verfügung hält, während der andere ein Signal entsprechend der Frequenz eine bestimmte Zeit nach Auftreten der Störung zur Verfügung hält.

Die Erfindung umfaßt auch die Verwendung einer Einrichtung vorstehender Art in einer adaptiven Frequenzregelung für elektrische Energieversorgungsnetze, welche abhängig von der Frequenzänderungsgeschwindigkeit von einem bestimmten Regelmodus auf einen anderen Regelmodus umschaltbar ist, wobei die Umschaltung erfolgt, sobald das Ausgangssignal des Vergleichers bzw. der Multiplikationsschaltung einen bestimmten Grenzwert übersteigt.

Hierbei kann die Umschaltung vorgenommen werden, sobald das Ausgangssignal der vorerwähnten Rechenschaltung einen bestimmten Grenzwert übersteigt. Insbesondere kann dabei die Umschaltung von einer progressiven Regelung auf eine proportionale Regelung vorgenommen werden.

Einige Ausführungsbeispiele werden nachfolgend anhand der Zeichnung näher erläutert. Es stellt dar

Fig. 1 ein Blockschaltbild einer Einrichtung zur Bestimmung von die Netzfrequenz beeinflussenden Störungen mit Mitteln zur Anzeige der am Störungsort abfließenden oder nicht mehr verfügbaren Leistung und Mitteln zur Anzeigung der Entfernung zum Störungsort oder der wirksamen Ersatzimpedanz des Netzes zwischen Beobachtungsort und Störungsort,

Fig. 2 ein vereinfachtes Schaltbild eines Maximalwerthaltekreises, welcher der Meßschaltung zur Ermittlung der Frequenzänderungsgeschwindigkeit zugeordnet ist,

Fig. 3 ein vereinfachtes Schaltbild der Verzögerungs- und Tastschaltung mit dem zugehörigen Taktsignalgeber,

Fig. 4 ein Blockschaltbild einer Frequenzregeleinrichtung zur adaptiven Frequenzregelung und

Fig. 5 ein Diagramm, welches die Regelkennlinien der Regeleinrichtung nach Fig. 4 aufzeigt.

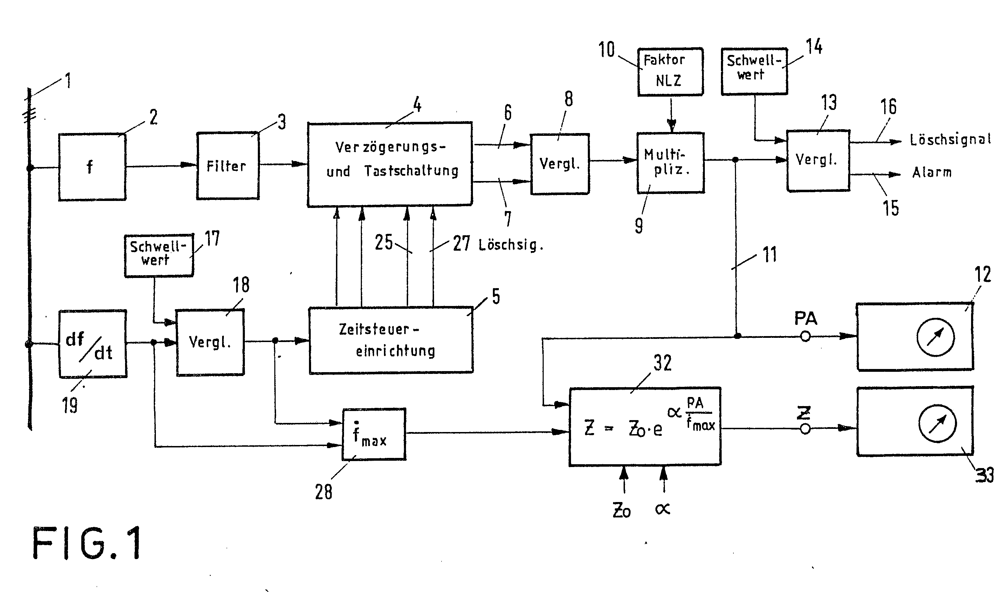

An ein in Fig. 1 schematisch bei 1 angegebenes Energieversorgungsnetz ist ein Meßwertgeber 2 angeschlossen, der an seinem Ausgang ein Signal entsprechend der jeweiligen augenblicklichen Netzfrequenz darbietet. Dieses Signal wird durch ein Filter 3 geführt, um ein ständig vorhandenes Frequenzrauschen auszufiltern, so daß die nachgeschalteten Baugruppen nicht auf kleine, ständig vorhandene Frequenzschwankungen ansprechen, die beispielsweise durch Maschinenpendelungen hervorgerufen werden.

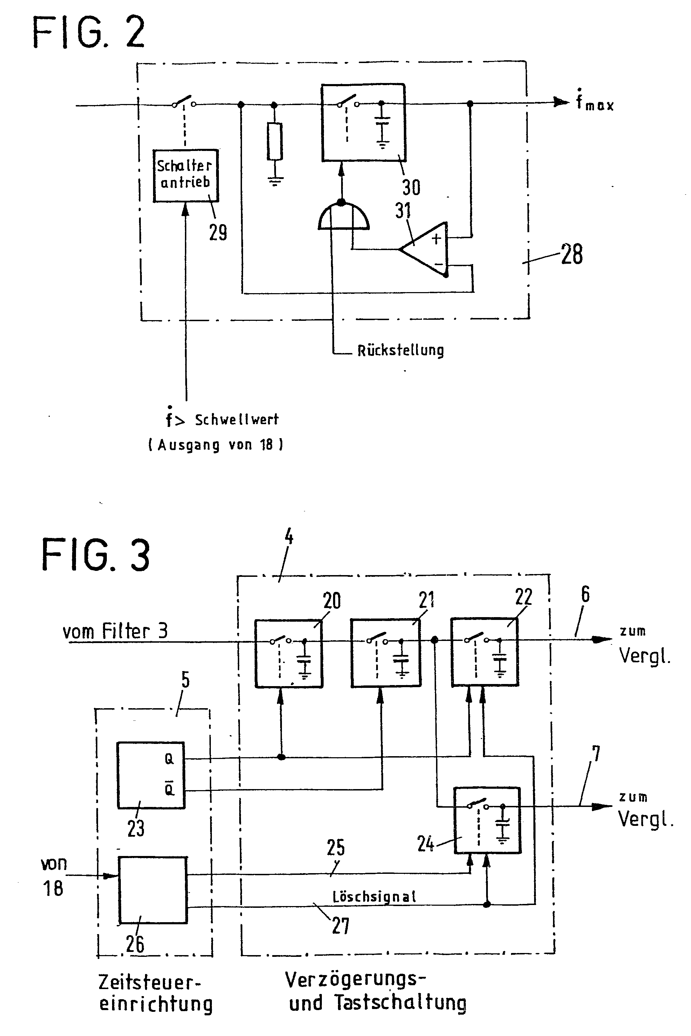

Das Filterausgangssignal speist eine Verzögerungs- und Tastschaltung 4, welche durch eine Zeitsteuereinrichtung 5 gesteuert wird und deren Einzelheiten weiter unten im Zusammenhang mit Fig. 3 näher erläutert werden. Ein Ausgang 6 der Verzögerungs- und Tastschaltung 4 bietet ein Signal entsprechend der Frequenz dar, welche im Netz 1 unmittelbar vor Auftreten der Störung festgestellt wurde. Ein Ausgang 7 der Schaltung 4 führt ein Signal, welches der Frequenz im Netz 1 kurze Zeit nach dem Störungsereignis entspricht. Bei den praktisch zu untersuchenden Netzen wählt man die soeben erwähnte Zeitspanne etwa 10 Sekunden.

Die Ausgangssignale der Leitungen 6 und 7 werden in dem Vergleicher 8 miteinander verglichen und das Signal entsprechend dem Vergleichsergebnis gelangt zu einer Multiplikationsschaltung 9, in der eine Multiplikation mit einem Proportionalitätsfaktor erfolgt, der abhängig von den Eigenschaften des beobachteten Netzes zu wählen ist und im allgemeinen als Netzleistungszahl bezeichnet wird. Die Netzleistungszahl kennzeichnet die Größe der störungsbedingenden Leistung je Einheit der Frequenzabweichung. Die Baugruppe zur Einstellung der Netzleistungszahl ist in Fig. 1 mit 10 bezeichnet. Über eine Leistung 11 gelangt das Ausgangssignal der Multiplikationsschaltung 9 zu einer Anzeigerichteinrichtung 12, von welcher eine Anzeige entsprechend der störungsbedingenden Leistung ablesbar ist. Es kann sich hier um eine Information über die Leistung eines ausgefallenen Kraftwerkes, über die Höhe eines Lastabwurfes oder über eine Kurzschlußleistung handeln.

Das Ausgangssignal der Multiplikationsschaltung 9 wird außerdem in einem Vergleicher 13 mit einem wählbaren Sollwertsignal eines einstellbaren Sollwertgebers 14 verglichen und kann dann über eine Leitung 15 einen Alarm auslösen, wenn eine bestimmte Frequenzabweichung überschritten wird. Außerdem gibt der Vergleicher 13 über einen weiteren Ausgang 16 ein Löschsignal ab, das zur Rückstellung bestimmter Baugruppen der Schaltung, vornehmlich in der Verzögerungs- und Tastschaltung dient, worauf weiter unten noch näher eingegangen wird. Diese Rückstellung erfolgt, wenn die auftretende Frequenzabweichung und damit die störungsbedingende Leistung einen bestimmten Grenzwert nicht überschreitet.

Die Zeitsteuereinrichtung 5 wird zur Abgabe von Steuersignalen für die Verzögerungs- und Tastschaltung 4 in Lauf gesetzt, wenn die Frequenzänderungsgeschwindigkeit einen bestimmten, von dem Schwellenwertgeber 17 vorgegebenen Schwellenwert überschreitet. Diese Bedingung wird durch einen Vergleicher 18 bestimmt, dessen einem Eingang das Ausgangssignal des Schwellenwertgebers 17 zugeführt wird, während an den anderen Eingang des Vergleichers 18 das Ausgangssignal eines Meßwertgebers 19 gelegt ist, durch welchen die Frequenzänderungsgeschwindigkeit festgestellt wird.

Aus Fig. 3 ist ersichtlich, daß die Verzögerungs- und Tastschaltung 4 eine Kette von vorliegend drei hintereinandergeschalteten Tast- und Haltegliedern 20, 21 und 22 aufweist. Die schematisch angedeuteten Steuereingänge der Tast- und Halteglieder 20 und 21 sind an einen quarzgesteuerten Taktsignalgeber derart angeschlossen, daß die Tast- und Halteglieder 20 und 21 wechselweise geschaltet werden und das vom Filter 3 her eingangsseitig anstehende Signal entsprechend dem augenblicklichen Wert der Frequenz auf dem Netz 1 taktweise registerartig durch die Tast- und Halteglieder 20 und 21 weitergegeben wird, derart, daß aufgrund einer entsprechenden Wahl der Taktfrequenz des Taktgebers 23 am Ausgang des Tast- und Haltegliedes 21 zu jedem Zeitpunkt ein Signal abnehmbar ist, das der Frequenz des Netzes zu einer etwa eine Sekunde bis zwei Sekunden früheren Zeit entspricht. Dieses Signal steht dann in dem Tast- und Haltekreis 22 zur Verfügung, bis eine Löschung nach beispielsweise etwa 70 Sekunden vorgenommen wird.

Der Ausgang des Tast- und Haltegliedes 21 ist außerdem mit einem vierten Tast- und Halteglied 24 verbunden, das über eine Steuerleitung 25 mit einer der Zeitsteuereinrichtung angehörenden Zeitsteuerschaltung 26 verbunden ist, die durch das Ausgangssignal des Vergleichers 18 in Lauf gesetzt wird, sobald eine bedeutsame Frequenzänderungsgeschwindigkeit auftritt. Die Zeitsteuerschaltung 26 bewirkt, daß das etwa 10 Sekunden nach Auftreten einer Störung am Ausgang des Tast- und Haltegliedes 21 auftretende Signal von dem Tast- und Halteglied 24 getastet und gespeichert wird, während in dem Tast- und Halteglied 22 das Signal konserviert wird, das etwa 1 Sekunde vor Auftreten des maximalen Freqzenzabfalls aufgrund der Störung vom Filter 3 abnehmbar ist. Die Ausgangssignale der Tast- und Halteglieder 22 und 24 gelangen zu dem Vergleicher 8 und werden in der zuvor beschriebenen Weise verarbeitet. Etwa 70 Sekunden nach Auftritt einer Störung werden die Tast- und Halteglieder 22 und 24 durch ein Signal der Löschsignalausgangsleitung 27 der Zeitsteuerschaltung 26 zurückgestellt, um die Schaltung für eine neue Messung vorzubereiten. Löschsignale, welche am Ausgang 16 des Vergleichers 13 abnehmbar sind, können in geeigneter logischer Verknüpfung mit den Löschsignalen der Leitung 27 zur Rückstellung der Schaltung mit herangezogen werden und dienen außerdem zur Rückstellung der Anzeigemittel der Einrichtung, insbesondere, wenn es sich bei diesen um Digitalanzeiger handelt.

An den Ausgang des Meßwertgebers 19 ist außerdem ein auf die maximal auftretende Frequenzänderungsgeschwindigkeit ansprechender Maximalwerthaltekreis 28 angeschlossen, der in Betrieb gesetzt wird, sobald die Frequenzänderungsgeschwindigkeit den durch den Schwellenwertgeber 17 vorgegebenen Schwellenwert übersteigt. Hierzu steht in der aus Fig. 2 ersichtlichen Weise ein Schaltantrieb 29 des Haltekreises 28 mit der Ausgangsleitung des Vergleichers 18 in Verbindung. Das Festhalten des Signals entsprechend der maximalen Frequenzänderungsgeschwindigkeit geschieht in einem Tast- und Halteglied 30, dessen Steuereingang mit einem Differentialverstärker 31 gekoppelt ist, welcher die Signalwerte am Eingang und am Ausgang des Tast- und Haltegliedes 30 miteinander vergleicht. Einzelheiten kann der Fachmann der Fig. 2 ohne weiteres entnehmen. Es sei hier bemerkt, daß in dem Tast- und Haltekreis 30 vorzugsweise die maximale negative Frequenzänderungsgeschwindigkeit festgehalten wird, da es vornehmlich Frequenzabnehmen oder Frequenzeinbrüche im Netz sind, welche bezüglich der Anzeige interessieren und denen entgegenzuwirken ist.

Die Ausgangssignale der Multiplikationsschaltung 9 einerseits und des Maximalwerthaltekreises andererseits werden, wie aus Fig. 1 zu entnehmen ist, eine Rechenschaltung 32 eingegeben, welche über entsprechende weitere Eingänge wählbare Signale zur Darstellung von Konstanten empfängt. Die Rechenschaltung 32 bildet ein Ausgangssignal Z nach der Gleichung

$$Z = Z_0 e^{\alpha \frac{PA}{\dot{f}_{max}}}$$

worin $Z_0$ eine als wählbarer Signalwert eingebbare Konstante, $\alpha$ eine ebenfalls als wählbares Signal eingebbare, weitere Konstante, PA das Ausgangssignal der Multiplikationsschaltung 9 und $\dot{f}_{max}$ das Ausgangssignal des Maximalwerthaltekreises 28 bedeuten. Das Ausgangssignal der Rechenschaltung 32 gelangt zu einer zweiten Anzeigeeinrichtung 33, von welcher bei Auftreten einer Störung je nach Eichung eine Anzeige entsprechend der Entfernung zwischen Beobachtungsort und Störungsort oder eine Anzeige entsprechend der Ersatzimpedanz zwischen Beobachtungsort und Störungsort gewonnen werden kann. Dies beruht auf der Erkenntnis, daß die genannte Entfernung bzw. der genannte Impedanzwert von dem Verhältnis aus störungsbedingender Leistung und maximaler Frequenzänderungsgeschwindigkeit nach einer exponentiellen Funktion abhängig ist.

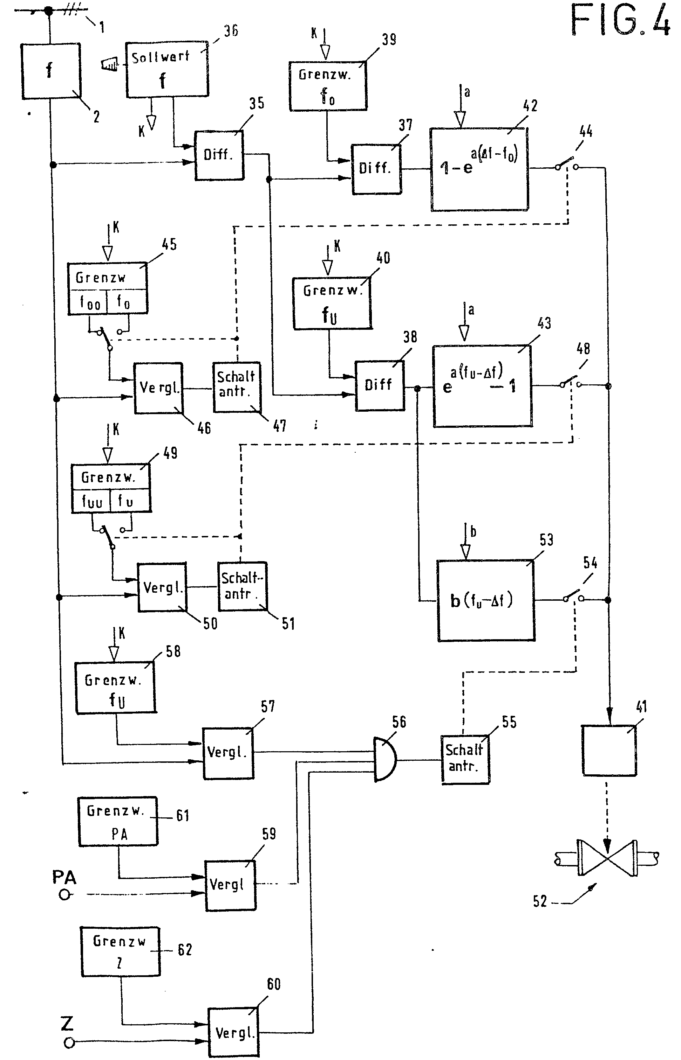

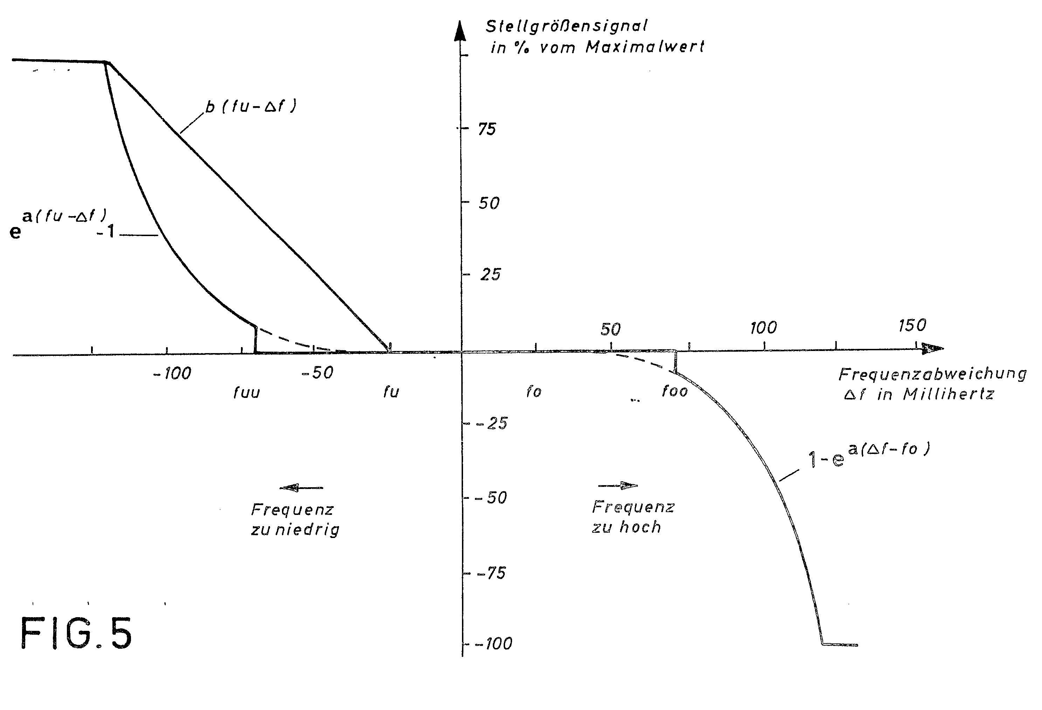

Anhand der Fig. 4 und 5 soll nun die Verwendung einer Einrichtung nach den Fig. 1 bis 3 in der adaptiven Frequenzregeleinrichtung erläutert werden.

Die Regelstrecke umfaßt wiederum das Energieversorgungsnetz 1, an welches der Meßwertgeber 2 zur Erzeugung eines Signals entsprechend der augenblicklichen Frequenz auf dem Netz 1 angeschlossen ist. In einem Differenzverstärker 35 erfolgt der Vergleich des Signals entsprechend dem Istwert der Frequenz mit einem Signal entsprechend dem Sollwert der Frequenz, wobei letztgenanntes Signal durch einen einstellbaren Sollwertgeber 36 wählbar vorgegeben wird. Das Ausgangssignal des Differenzverstärkers 35 wird in weiteren, nachgeschalteten Differenzverstärkern 37 und 38 mit Signalen entsprechend der oberen Grenze $f_0$ der Frequenzabweichung bzw. der unteren Grenze $f_u$ der Frequenzabweichung verglichen, wobei die zuletzt genannten Grenzwerte durch Grenzwertgeber 39 bzw. 40 vorgegeben werden und mit $f_0$ bzw. $f_u$ die Frequenzwerte bestimmen, welche von der tatsächlichen Frequenz auf dem Netz 1 überschritten bzw. unterschritten werden müssen, um einen Regelvorgang auszulösen. Hierauf wird nachfolgend noch genauer eingegangen werden. Es sei hier aber bemerkt, daß die Verarbeitung der Ausgangssignale der Grenzwertgeber 39 und 40 in den Differenzverstärkern 37 bzw. 38 nicht der Auslösung des Regelvorganges, sondern einer bestimmten Signalverarbeitung dient, um aus dem durch Sollwert-Istwertvergleich im Differenzverstärker 35 erzeugten Fehlersignal nach einer bestimmten Funktion ein Steuersignal für den Stelltrieb 41 abzuleiten. Zu diesem Zwecke ist dem Differenzverstärker 37 eine Rechenschaltung 42 nachgeschaltet, die folgende Rechenoperation verwirklicht:

$$1 - e^{a(\Delta f - f_0)}$$

Hierin bedeutet a einen als wählbares Signal eingebbaren Faktor und $(\Delta f - f_0)$ das Ausgangssignal des Differenzverstärkers 37.

Dem Differenzverstärker 38 ist eine Rechenschaltung 43 nachgeschaltet, welche folgende Rechenoperation verwirklicht:

$$e^{\,a(f_u - \Delta f)} - 1$$

Hierin ist wiederum a ein als wählbares Signal eingebbarer Faktor und $(f_u - \Delta f)$ ist das Ausgangssignal) des Differenzverstärkers 38. Das unter Einsatz der Rechenschaltung 42 weiterverarbeitete Ausgangs-Fehlersignal des Differenzverstärkers 35 gelangt durch Schließen eines Schalters 44 zur Wirkung an dem Stelltrieb 41, wenn die tatsächliche Frequenz auf dem Netz 1 einen erhöhten oberen Grenzwert $f_{00}$ überschreitet, welcher durch den Grenzwertgeber 45 vorgegeben wird und in dem Vergleicher 46 mit dem Signal entsprechend dem Istwert der Frequenz verglichen wird. Der Ausgang des Vergleichers 46 erregt dann einen Schaltantrieb 47, welcher zur Betätigung des Schalters 44 dient und außerdem den mit einem Eingang des Grenzwertgebers 45 verbundenen Eingang des Vergleichers 46 auf einen anderen Ausgang des Grenzwertgebers 45 umschaltet, der einen näher bei der Sollwertfrequenz liegenden oberen Frequenzwert vorgibt, dergestalt, daß der die Rechenschaltung 42 enthaltende Kanal der Regelschaltung ein Hystereseverhalten aufweist und in Betrieb geht, wenn die Istfrequenz den Frequenzwert $f_{00}$ übersteigt und erst wieder abgeschaltet wird, wenn der Istwert der Frequenz unter $f_0$ abgefallen ist. Selbstverständlich kann der dem Vergleicher 46 zuzuführende Grenzwert entsprechend der Frequenz $f_0$ auch von dem Grenzwertgeber 39 abgenommen werden, was jedoch in Fig. 4 aus Gründen besserer Übersichtlichkeit des Schaltbildes nicht gezeigt ist. Aus Fig. 4 ist weiter zu ersehen, daß die Grenzwertgeber 39, 40, 45, 49 und 58 eine durch einen Pfeil k angedeutete Kopplung zum Sollwertgeber 36 besitzen, um die jeweils von den Grenzwertgebern gelieferten Grenzwerte entsprechend zu korrigieren oder nachzuführen, wenn der Frequenzsollwert willkürlich verstellt wird.

Das unter Einsatz der Rechenschaltung 43 verarbeitete Fehlerausgangssignal des Differenzverstärkers 35 gelangt bei Schließung des Schalters 48 am Stelltrieb 41 zur Wirkung, wenn der Istwert der Frequenz unter einen zweiten unteren Grenzwert $f_{uu}$ der Frequenz abgefallen sein sollte. Der letztgenannte Grenzwert wird durch den Grenzwertgeber 49 bereitgestellt und in dem Vergleicher 50 mit dem Ausgangssignal des Meßwertgebers 2 verglichen. Das Ausgangssignal des Vergleichers 50 erregt einen Schaltantrieb 51 und dieser wiederum betätigt den Schalter 48 sowie auch einen dem Grenzwertgeber 49 zugeordneten Umschalter, um hier in ähnlicher Weise ein Hystereseverhalten den die Rechenschaltung 43 enthaltenen Kanals zu verwirklichen, wie dies analog im Zusammenhang mit dem Grenzwertgeber 45, dem Vergleicher 46 und dem Schaltantrieb 47 beschrieben wurde.

Fig. 5 macht deutlich, daß, solange die Frequenzänderungsgeschwindigkeit bestimmte Werte nicht überschreitet, Lastveränderungen des Netzes, welche Frequenzabweichungen im Bereiche oberhalb eines zweiten oberen Grenzwertes $f_{00}$ bzw. im Bereich unterhalb eines zweiten unteren Grenzwertes $f_{uu}$ verursachen, eine progressive Regelung aufgrund der in den Rechenschaltungen 42 und 43 eingeführten Exponentialfunktionen nach sich ziehen. Der Stelltrieb 41 bewirkt dann eine entsprechende Verstellung eines Ventils der Druckmittelzuleitung zu einer einen Generator treibenden Kraftmaschine, wie in Fig. 4 schematisch bei 52 angedeutet ist.

Übersteigt jedoch bei kritischer Frequenzänderungsgeschwindigkeit die Laständerung im Netz einen bestimmten Wert, so erfolgt zu einer möglichst raschen Stützung der Frequenz im Energieversorgungsnetz 1 die Regelung nach einer proportionalen Kennlinie. Hierzu wird das Ausgangssignal des Differenzverstärkers 38 in der Rechenschaltung 53 nach folgender Funktion weiterverarbeitet:

$$b\,(f_u - \Delta f)$$

Hierin bedeutet b eine als wählbares Signal in die Schaltung 53 eingebbare Konstante und $(f_u - \Delta f)$ ist das Ausgangssignal des Differenzverstärkers 38. Das Ausgangssignal der Rechenschaltung 53 gelangt als Steuersignal zu dem Stelltrieb 41, wenn der Schalter 54 geschlossen wird. Dies ist der Fall, wenn der Schaltantrieb 55 aufgrund der Erfüllung der Eingangsbedingungen zu dem UND-Schaltelement 56 erregt wird.

Die Regelung nach einer Proportionalkennlinie wird nur bei negativen Frequenzabweichungen eingesetzt, welche dem UND-Schaltelement 56 durch den Vergleicher 57 signalisiert werden, welcher den Istwert der Frequenz mit dem bzw. einem unteren Grenzwert $f_u$ vergleicht, der von dem Grenzwertgeber 58 geliefert wird oder auch von dem oben schon erwähnten Grenzwertgeber 40 abgenommen werden kann.

Aus Fig. 4 ist weiterhin zu entnehmen, daß dem UND-Schaltelement 56 als weitere Eingangssignale solche Signale zugeführt werden, die von der Schaltung nach Fig. 1 abgeleitet sind. In Fig. 4 sind die Klemmen PA und Z eingezeichnet, welche den Ausgang der Multiplikationsschaltung 9 bzw. der Rechenschaltung 32 darstellen. Die an den besagten Klemmen dargebotenen Signale werden in Vergleichern 59 bzw. 60 mit entsprechenden Grenzwerten von Grenzwertgebern 61 bzw. 62 verglichen, derart, daß die für die Durchschaltungen des UND-Schaltelementes 56 erforderlichen Eingangssignale vollständig zur Verfügung stehen, wenn die störungsbedingte Leistung einen bestimmten Grenzwert überschreitet und wenn die wirksame Ersatzimpedanz zwischen Beobachtungsort und Störungsort eine bestimmte Abweichung von einem Grenzwert hat.

Es zeigt sich, daß die hier vorgeschlagene Regeleinrichtung für alle Fälle des Netzbetriebes und auftretenden Netzstörungen eine jeweils geeignete Regelcharakteristik bereithält und gleichzeitig eine vollständige Information über Art und Ort der Störung zu liefern vermag. Die durch die Anzeigegeräte 12 und 33 gewinnbaren Informationen gestatten im allgemeinen die genaue Lokalisierung der Störung, beispielsweise den Ausfall von Kraftwerken, und dies über Entfernungen von mehreren hundert Kilometern in kürzester Zeit ohne Einrichtung einer gesonderten Nachrichtenverbindung.

**Patentansprüche**

1. Einrichtung zur Bestimmung von die Netzfrequenz beeinflussenden Störungen in elektrischen Energieversorgungsnetzen, mit einer Meßschaltung (2, 3, 4, 8) zur Ermittlung der Abweichung der Netzfrequenz von einer Sollwertfrequenz und einer weiteren Meßschaltung (17, 18, 19) zur Ermittlung der Frequenzänderungsgeschwindigkeit, dadurch gekennzeichnet, daß die erstgenannte Meßschaltung (2, 3, 4, 8) eine Verzögerungs- und Tastschaltung (4) mit mehreren Ausgängen (6, 7) enthält, von deren einem ein Signal entsprechend der Frequenz unmittelbar vor Auftreten der Störung und von deren weiterem ein derartiges Signal kurze Zeit, beispielsweise 10 Sekunden, nach Auftreten der Störung abnehmbar ist, daß ferner eine an die weitere Meßschaltung (17, 18, 19) angeschlossene Zeitsteuereinrichtung (5) mit mehreren Taktsignalausgängen zur Steuerung der Verzögerungs- und Tastschaltung (4) vorgesehen ist und daß die Ausgangssignale der Verzögerungs- und Tastschaltung (4) in einen Vergleicher (8) einspeisbar sind, dessen Ausgang mit einem Anzeigegerät (12) gekoppelt ist, von welchem eine Anzeige entsprechend der störungsbedingenden Leistung ablesbar ist.

2. Einrichtung nach Anspruch 1, dadurch gekennzeichnet, daß die Kopplung des Vergleichers (8) mit dem Anzeigegerät (12) über eine Multiplikationsschaltung (9) vorgenommen ist, in welcher das Vergleicherausgangssignal mit einem wählbaren (10) Faktor multipliziert wird.

3. Einrichtung nach Anspruch 2, dadurch gekennzeichnet, daß die Multiplikationsschaltung (9) und ein der zweiten Meßschaltung (17, 18, 19) nachgeschalteter Maximalwerthaltekreis (28) eine Rechenschaltung (32) speist, welche folgende Rechenoperation durchführt:

$$Z = Z_0 e^{\alpha \frac{PA}{f_{max}}}$$

worin Z das Ausgangssignal der Rechenschaltung bezeichnet, $Z_0$ und $\alpha$ als wählbare Signale eingebbare Faktoren sind, PA das Ausgangssignal der Multiplikationsschaltung (9) bezeichnet und $f_{max}$ das Ausgangssignal des Maximalwerthaltekreises (28) ist und wobei das Ausgangssignal der Rechenschaltung einem weiteren Anzeigegerät (33) zugeführt wird, von welchem eine Anzeige entsprechend der Entfernung zwischen Beobachtungsort und Störungsort oder entsprechend der wirksamen Ersatzimpedanz im beobachteten Netz zwischen Beobachtungsort und Störungsort ablesbar ist.

4. Einrichtung nach einem der Ansprüche 1 bis 3, dadurch gekennzeichnet, daß die Verzögerungs- und Tastschaltung (4) zwei hintereinandergeschaltete, wechselweise betätigte und eingangsseitig von einem Frequenz-Istwertsignal beaufschlagte Tast- und Haltekreise (20, 21) sowie diesen jeweils nachgeschaltete weitere Tast- und Haltekreise (22, 24) als Speicherstufen enthält, von welchletzteren einer durch die Zeitsteuereinrichtung (5) derart gesteuert ist, daß er vom Ausgang des zuerst genannten Tast- und Haltekreispaares (21, 20) ein Signal entsprechend der Frequenz vor Auftreten der Störung zur Verfügung hält, während der andere (24) ein Signal entsprechend der Frequenz eine bestimmte Zeit nach Auftreten der Störung zur Verfügung hält.

5. Verwendung einer Einrichtung nach einem der Ansprüche 1 bis 4 in einer adaptiven Frequenzregeleinrichtung für elektrische Energieversorgungsnetze, welche abhängig von der Frequenzänderungsgeschwindigkeit von einem bestimmten Regelmodus auf einen anderen Regelmodus umschaltbar ist, dadurch gekennzeichnet, daß die Umschaltung erfolgt, sobald das Ausgangssignal des Vergleichers (8) bzw. der Multiplikationsschaltung (9) einen bestimmten Grenzwert (61) übersteigt.

6. Verwendung nach Anspruch 5 mit einer Einrichtung nach Anspruch 3, dadurch gekennzeichnet, daß die Umschaltung erfolgt, sobald das Ausgangssignal der Rechenschaltung (32) einen bestimmten Grenzwert (62) übersteigt.

7. Verwendung nach Anspruch 5 oder 6, dadurch gekennzeichnet, daß die Umschaltung von einer progressiven Regelung (42, 43) auf eine proportionale Regelung (53) vorgenommen wird.

**Claims**

1. An arrangement for detecting mains frequency influencing disturbances in electric power supply systems, comprising a measuring circuit for measuring the deviation of the mains frequency from a desired frequency and another measuring circuit for measuring the rate of frequency change, characterized in that the first-mentioned measuring circuit (2, 3, 4, 8) includes a delay and sample circuit (4) having a plurality of output terminals (6, 7) and adapted to deliver from one of said output terminals a signal corresponding to the frequency measured immediately before the occurrence of the disturbance and from the other of said output terminals a signal a short time, e. g., 10 seconds, after the occurrence of the disturbance, a timer (5) having a plurality of clock outputs for controlling the delay and sample circuit is connected to the additional measuring circuit (17, 18, 19) and the output signals of the delay and sample circiut are adapted to be delivered to a comparator (8), which has an output terminal coupled to an indicator (12) from which an indication corresponding to the power which causes the disturbance can be read.

2. An arrangement according to claim 1, characterized in that the comparator (8) is coupled to the indicator (12) by a multiplying circuit (9) for multiplying the output signal of the comparator with a selectable (10) factor.

3. An arrangement according to claim 2, characterized in that the multiplication circuit (9) and a peak-holding circuit (28) which succeeds the second measuring circuit (17, 18, 19) feeds an arithmetic circuit (32) for performing the following arithmetic operation

$$Z = Z_0 e^{\alpha \frac{PA}{f_{max}}}$$

wherein Z is the output signal of the arithmetic circuit, $Z_0$ and $\alpha$ are factors adapted to be entered as selectable signals, PA is the output signal of the multiplying circuit (9) and $f_{max}$ is the output signal of the peak-holding circuit (28), and the output signal of the arithmetic circuit is delivered to another indicator (33), from which an indication of the distance between the monitoring location and the origin of the disturbance or of the effective equivalent impedance of the monitored mains between the monitoring location and the origin of the disturbance can be read.

4. An arrangement according to any of claims 1 to 3, characterized in that the delay and sample circuit comprises two series-connected sample and hold circuits (20, 21), which are operated in alternation and a supplied at their inputs with an actual-frequency signal, and respective succeeding additional sample and hold circuits (22, 24) serving as storage stages, one of which is controlled by the timer (5) in such a manner that it makes available a signal corresponding to the frequency before the occurrence of the disturbance from the output of the first-mentioned pair of sample and hold circuits (21, 20) and the other (24) makes available a signal corresponding to the frequency measured a certain time after the occurrence of the disturbance.

5. The use of an arrangement according to any of claims 1 to 4 in an adaptive automatic frequency control system for electric power supply systems, which is adapted to be switched from one predetermined automatic control mode to another in dependence on the rate of frequency change, characterized in that the switching is effected as soon as the output signal of the comparator (8) or of the multiplying circuit (9) exceeds a predetermined limit (61).

6. The use according to claim 5 of an arrangement according to claim 3, characterized in that the switching is effected as soon as the output signal of the arithmetic circuit (32) exceeds a predetermined limit (62).

7. The use according to claim 5 or 6, characterized in that the switching is effected from a progressive automatic control (42, 43) to a proportional automatic control (53).

## Revendications

1. Dispositif pour déterminer des perturbations influençant la fréquence de réseau dans des réseaux électriques d'alimentation en énergie, comportant un circuit de mesure (2, 3, 4, 8) pour déterminer l'écart entre la fréquence de réseau et une fréquence de consigne ainsi qu'un autre circuit de mesure (17, 18, 19) pour déterminer la vitesse de fréquence de fréquence, caractérisé en ce que le circuit de mesure cité en premier (2, 3, 4, 8) comporte un circuit de retardement et d'analyse (4) pourvu de plusieurs sorties (6, 7) dont l'une fournit un signal correspondant à la fréquence existant avant l'apparition de la perturbation et dont l'autre fournit un tel signal correspondant à la fréquence existant un court moment, notamment environ dix secondes, après l'apparition de la perturbation, en ce qu'en outre, il est prévu un dispositif de minutage (5) relié à l'autre circuit de mesure (17, 18, 19) et comportant plusieurs sorties de signaux de minutage servant à la commande du circuit de retardement et d'analyse (4), et en ce que les signaux de sortie du circuit de retardement et d'analyse sont appliqués à un comparateur (8) dont la sortie est reliée à un appareil indicateur (12) à partir duquel on peut lire une indication correspondant à la puissance résultant de la perturbation.

2. Dispositif selon la revendication 1, caractérisé en ce que le couplage du comparateur (8) avec l'appareil indicateur (12) est assuré par l'intermédiaire d'un circuit de multiplication (9) dans lequel le signal de sortie du comparateur est multiplié par un facteur sélectionnable (10).

3. Dispositif selon la revendication 2, caractérisé en ce que le circuit de multiplication (9) et un circuit de maintien de valeur maximale (28), branché en aval du second circuit de mesure (17, 18, 19), alimentent un circuit de calcul (32) qui effectue l'opération de calcul suivante:

$$Z = Z_0 e^{\alpha \frac{PA}{f_{max}}}$$

où Z désigne le signal de sortie du circuit de calcul, $Z_0$ et $\alpha$ désignent des facteurs pouvant être introduits comme signaux sélectionnables, PA désigne le signal de sortie du circuit de multiplication (9) et $f_{max}$ désigne le signal de sortie du circuit de maintien de valeur maximale (28), le signal de sortie du circuit de calcul étant appliqué à un autre appareil indicateur (33) à

13 **0 012 961** 14

partir duquel on peut lire une indication correspondant à la distance d'éloignement entre le lieu d'observation et le lieu de perturbation, ou bien correspondant à l'impédance équivalente efficace existant dans le réseau contrôlé entre le lieu d'observation et le lieu de perturbation.

4. Dispositif selon l'une quelconque des revendications 1 à 3, caractérisé en ce que le circuit de retardement et d'analyse (4) contient, comme étages de mémorisation, deux montages d'analyse et maintien (20, 21) branchés en série, actionnés alternativement, sollicités du côté d'entrée par un signal de valeur réelle de fréquence et en aval desquels sont connectés d'autres montages d'analyse et maintien (22, 24) dont l'un est commandé par le dispositif de minutage de telle sorte qu'il maintienne à disposition, à partir de la sortie de la paire de montages d'analyse et maintien (21, 20) citée en premier, un signal correspondant à la fréquence existant avant l'apparition de la perturbation, tandis que l'autre montage (24) maintient à disposition un signal correspondant à la fréquence existant un temps déterminé après apparition de la perturbation.

5. Utilisation d'un dispositif conforme à l'une quelconque des revendications 1 à 4 dans un dispositif adaptatif de régulation de fréquence pour des réseaux électriques d'alimentation en énergie, qui peut être commuté, en fonction de la vitesse de variation de fréquence, d'un mode déterminé de régulation sur un autre mode de régulation, caractérisée en ce que la commutation s'effectue aussitôt que le signal de sortie du comparateur (8) ou du circuit de multiplication (9) dépasse une valeur limite déterminée (61).

6. Utilisation selon la revendication 5 avec un dispositif selon la revendication 3, caractérisée en ce que la commutation s'effectue aussitôt que le signal de sortie du circuit de calcul (32) dépasse une valeur limite déterminée (62).

7. Utilisation selon la revendication 5 ou 6, caractérisée en ce que la commutation est effectuée d'une régulation progressive (42, 43) à une régulation proportionnelle (53).

FIG.1

# FIG. 2

$\dot{f}_{max}$

Schalter antrieb

29

30

31

28

Rückstellung

$\dot{f} >$ Schwellwert

( Ausgang von 18 )

# FIG. 3

4

20    21    22    6

vom Filter 3

zum
Vergl.

5

Q

Q̄

23

7

24

zum
Vergl.

von
18

25

Löschsignal

26    27

Zeitsteuereinrichtung

Verzögerungs-
und Tastschaltung

FIG.4

0 012 961

Stellgrößensignal
in % vom Maximalwert

$b\,(fu - \Delta f)$

$e^{a(fu - \Delta f)} - 1$

75

50

25

50    100    150

Frequenzabweichung
$\Delta f$ in Millihertz

fuu    fu    fo    foo

-100    -50

-25

$1 - e^{a(\Delta f - fo)}$

-50

Frequenz
zu niedrig

Frequenz
zu hoch

-75

-100

FIG.5

0 012 961